# EUROPÄISCHE PATENTSCHRIFT

(11) **EP 1 050 967 B1**
(45) Veröffentlichungstag und Bekanntmachung des Hinweises auf die Patenterteilung: **27.07.2005**
(21) Anmeldenummer: 00109636.1
(22) Anmeldetag: 05.05.2000
(51) Int. Cl.: H03K 17/16, H03K 17/082

(54) **Schaltungsanordnung zur Ansteuerung eines Halbleiterschalters**
Circuit arrangement for driving a semi conductor switch
Montage pour la commande d'un commutateur semi-conducteur

(30) Priorität: 07.05.1999 DE 19921112
(43) Veröffentlichungstag der Anmeldung: 08.11.2000
(73) Patentinhaber: Infineon Technologies AG, 81669 München (DE)
(72) Erfinder: Auer, Frank, 85244 Röhrmoos (DE); Horchler, Wolfgang, 83026 Rosenheim (DE); Lenz, Michael, 85604 Zorneding (DE)
(74) Vertreter: Bickel, Michael

(56) Entgegenhaltungen:
- EP-A- 0 436 280
- EP-A- 0 760 555
- US-A- 5 598 119
- US-A- 5 828 539
- C.H.LIM AND W.R. DAASCH: "Output Buffers with self-adjusting slew rate and on-chip compensation" Februar 1998 (1998-02) , 1998 IEEE SYMPOSIUM ON IC/PACKAGE DESIGN INTEGRATION - PROCEEDINGS, SEITEN 51 - 55 XP002271653 (wie am 24. Feb. 2004 von der Webseite http://ieeexplore.ieee.org/search heruntergeladen) * Zusammenfassung *
- PATENT ABSTRACTS OF JAPAN vol. 1996, no. 04, 30. April 1996 (1996-04-30) -& JP 07 337070 A (HITACHI LTD), 22. Dezember 1995 (1995-12-22)

## Beschreibung

Die vorliegende Erfindung betrifft eine Schaltungsanordnung mit einem Halbleiterschalter und einer Ansteuerschaltung, die eine Eingangsklemme zum Anlegen eines Schaltsignals und eine an einen Steuereingang des Halbleiterschalters angeschlossene Ausgangsklemme zum Bereitstellen eines Ansteuersignals nach Maßgabe des Schaltsignals aufweist.

Derartige Schaltungsanordnungen dienen zum Schalten von Strömen beispielsweise in Schaltnetzteilen, Brückenschaltungen oder allgemein zum Anschalten einer in Reihe zur Lastrecke des Halbleiterschalters geschalteten Last an eine Versorgungsspannung. Die Schaltungsanordnungen sind dabei in der Lage verhältnismäßig große Ströme oder Spannungen bei kurzen Schaltzeiten zu schalten. Eine durch den Schaltvorgang hervorgerufene und von der Schaltung abgestrahlte elektromagnetische Strahlung ist um so energiereicher und hochfrequenter, und damit störender, je schneller der Halbleiterschalter schaltet, also vom leitenden in den sperrenden oder von dem sperrenden in den leitenden Zustand übergeht.

Ein zur Ansteuerung des Halbleiterschalters vorgesehenes, dem Steuereingang des Halbleiterschalters zugeführtes Ansteuersignal nimmt einen von zwei Ansteuerpegeln an, je nachdem ob der Halbleiterschalter leiten oder sperren soll. Zur Begrenzung der Störstrahlung weisen die bekannten Schaltungsanordnungen üblicherweise Ansteuerschaltungen auf, bei denen die Steilheit der Flanken der Ansteuersignale beim Wechsel von einem zum anderen Ansteuerpegel, und damit die Steilheit der Flanken des Ausgangssignals des Halbleiterschalters, begrenzt sind. Während des Schaltvorgangs treten Verluste an dem Halbleiterschalter auf, die besonders groß sind, wenn -wie bei der Ansteuerung induktiver Lasten in Brückenschaltungen- große Ströme während des Umschaltens über den Halbleiterschalter fließen. Die dabei am Halbleiterschalter in Wärme umgesetzte elektrische Leistung steigt mit zunehmender Schaltfrequenz an und kann erheblich zur Erwärmung der, üblicherweise als integrierte Schaltung ausgeführten, Steuerschaltung führen, was schlimmstenfalls zu einer Zerstörung von Bauteilen führt.

Gemäß der erfindungsgemäßen Schaltungsanordnung ist vorgesehen, die Steilheit des Ansteuersignals beim Übergang von einem zum anderen Ansteuerpegel temperaturabhängig einzustellen. Die Steilheit des Ansteuersignals nimmt insbesondere bei steigender Temperatur zu.

Ist die Temperatur der Schaltung in einem Temperaturbereich, in dem ein zusätzlicher Temperaturanstieg durch ein langsames Schalten des Halbleiterschalters ohne die Gefahr einer Zerstörung der Schaltung erfolgen kann, ist die Steilheit des Ansteuersignals reduziert, um die elektromagnetische Störstrahlung zu reduzieren. Steigt die Temperatur in der Schaltungsanordnung an und ist die Gefahr einer Zerstörung von Bauteilen bei einem weiteren Temperaturanstieg zu befürchten erhöht sich die Steilheit des Ansteuersignals bei einem Wechsel von einem zum anderen Ansteuerpegel, um ein schnelles Schalten des Halbleiterschalters zu erreichen und dadurch die zu einer weiteren Erwärmung führenden Verluste beim Schalten zu begrenzen. Zum Schutz der Bauelemente wird bei der Erfindung eine stärkere elektromagnetische Abstrahlung in Kauf genommen, um eine Überhitzung der Bauteile zu verhindern.

Gemäß einer bevorzugten Ausführungsform der Erfindung weist die Ansteuerschaltung eine Stromquelle und eine Stromsenke zur Bereitstellung bzw. zur Aufnahme eines temperaturabhängigen Stromes auf, wobei die Stromquelle und Stromsenke nach Maßgabe des Schaltsignals an die Ausgangsklemme anschließbar sind. Diese Ausführungsform findet insbesondere bei Einsatz eines Feldeffekttransistors als Halbleiterschalter Verwendung. Die Gate-Elektrode als Steueranschluß des Halbleiterschalters ist dabei an die Ausgangsklemme der Ansteuerschaltung angeschlossen. Die Leitfähigkeit des Feldeffekttransistors ist von der auf seiner Gate-Kapazität gespeicherten Ladung bzw. der Spannung zwischen dessen Gate-Elektrode und Source-Elektrode abhängig. Soll der Feldeffekttransistor leiten, fließt ein Strom über die Ausgangsklemme auf dessen Gate-Kapazität, wodurch die Gate-Source-Spannung, als für den Feldeffekttransistor maßgebliches Ansteuersignal ansteigt. Die Anstiegsgeschwindigkeit bzw. die Steigung des Ansteuersignals ist annäherungsweise proportional zu dem Kapazitätswert der Gate-Kapazität und dem auf die Gate-Kapazität fließenden Strom. Nimmt dieser Strom mit zunehmender Temperatur zu, wird der Feldeffekttransistor schneller leitend, wodurch die Verluste während der Übergangsphase vom sperrenden in den leitenden Zustand verringert werden. Soll der Feldeffekttransistor sperren, wird seine Gate-Kapazität mit einem durch die Stromsenke vorgegebenen, temperaturabhängigen Strom entladen, wobei die Entladung und damit der Übergang vom leitenden in den sperrenden Zustand um so schneller erfolgt, je größer der Strom ist.

Zum Anschließen der Stromquelle und der Stromsenke an die Ausgangsklemme sind vorzugsweise ein erster und zweiter Schalter vorgesehen, die nach Maßgabe des Schaltsignals geöffnet und geschlossen werden.

Die Stromquelle und die Stromsenke sind als steuerbare Stromquellen ausgebildet, denen von einem Temperatursensor ein Temperatursignal zur Einstellung des Stromes zugeführt ist.

Die Ansteuerschaltung weist vorzugsweise nur eine gesteuerte Stromquelle auf, die über einen ersten Stromspiegel als Stromquelle und über einen zweiten Stromspiegel als Stromsenke an die Ausgangsklemme anschließbar ist.

Die erfindungsgemäße Schaltungsanordnung wird nachfolgend anhand eines Ausführungsbeispiels in Figuren näher erläutert.

Es zeigen:
- Figur 1:: Schaltbild eines Ausführungsbeispiels der erfindungsgemäßen Schaltungsanordnung;
- Figur 2:: Temperaturabhängiger Verlauf des von einer Stromquelle der Ansteuerschaltung bereitgestellten Stromes;
- Figur 3:: beispielhafter Verlauf eines Schaltvorgangs;
- Figur 4:: Schaltbild eines weiteren Ausführungsbeispiels der erfindungsgemäßen Schaltungsanordnung.

In den Figuren bezeichnen, sofern nicht anders angegeben, gleiche Bezugszeichen gleiche Bauteile und Größen.

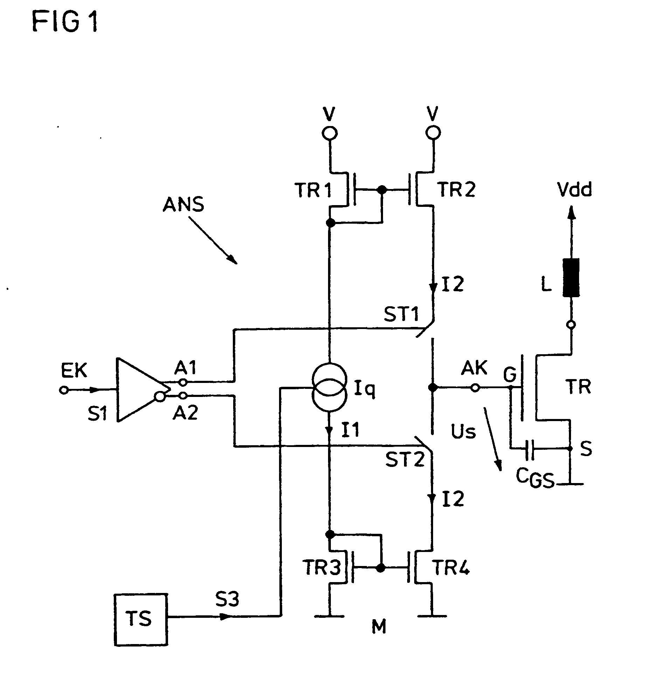

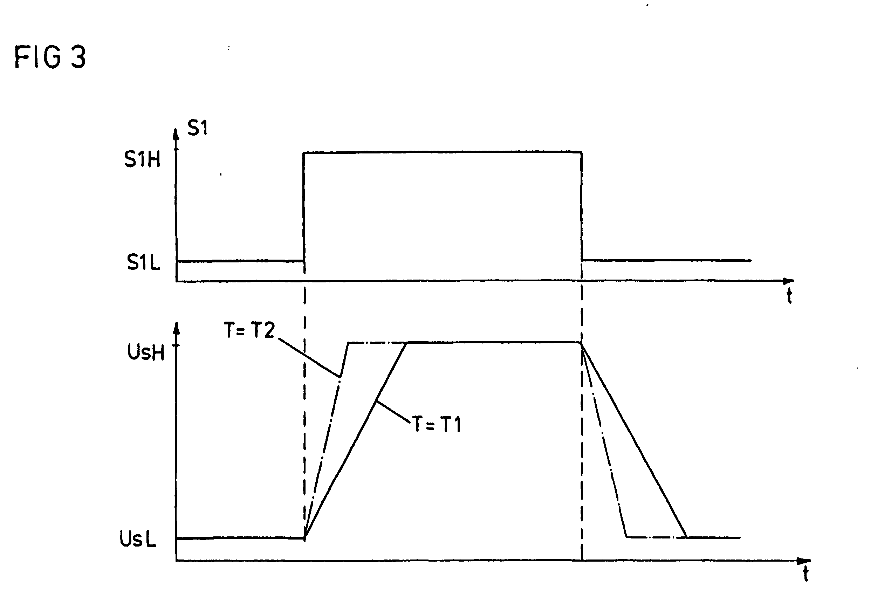

Figur 1 zeigt ein Ausführungsbeispiel der erfindungsgemäßen Schaltungsanordnung mit einem als Feldeffekttransistor, insbesondere als Leistungs-MOSFET, ausgebildeten Halbleiterschalter TR und einer Ansteuerschaltung ANS, die mittels einer Ausgangsklemme AK an die Gate-Elektrode G des Halbleiterschalters TR angeschlossen ist. Einer Eingangsklemme EK der Ansteuerschaltung ANS ist ein, vorzugsweise zweiwertiges, Schaltsignal zugeführt, nach dessen Maßgabe der Halbleiterschalter TR leiten oder sperren soll. In Figur 1 ist beispielhaft eine induktive Last L in Reihe zur Laststrecke des Halbleiterschalters TR dargestellt, die durch diesen an ein Versorgungspotential Vdd anschließbar ist.

Die Leitfähigkeit des Halbleiterschalters TR ist bestimmt durch ein von der Ansteuerschaltung ANS bereitgestelltes Ansteuersignal Us, das in dem dargestellten Ausführungsbeispiel die Spannung zwischen der Gate-Elektrode G und der Source-Elektrode S des Feldeffekttransistors TR ist. Der dargestellte n-leitende MOSFET TR beginnt zu leiten, wenn die Gate-Source-Spannung einen positiven Schwellenspannungswert übersteigt. Der Laststreckenwiderstand sinkt dann mit zunehmender Gate-Source-Spannung, bis der MOSFET TR vollständig ausgesteuert ist, so daß keine weitere Reduzierung des Laststrekkenwiderstandes möglich ist und der MOSFET maximal leitet. Annäherungsweise die gesamte Versorgungsspannung Vdd fällt dann an der Last L ab.

Idealerweise wird der Halbleiterschalter TR derart betrieben, daß er möglichst vollständig leitet oder vollständig sperrt, sein Laststreckenwiderstand also einen Maximalwert oder einen Minimalwert annimmt. Dementsprechend nimmt das Ansteuersignal Us im vorliegenden Beispiel einen unteren Ansteuerpegel an, um den Halbleiterschalter zu sperren, und einen oberen Ansteuerpegel an, um den Halbleiterschalter TR leitend zu machen.

Die Dauer eines Schaltvorgangs des Halbleiterschalters TR ist bestimmt durch die Zeitdauer, die für einen Übergang des Ansteuersignals Us von dem unteren zu dem oberen Ansteuerpegel, und umgekehrt, erforderlich ist. Diese Zeitdauer ist zum einen bestimmt durch den Kapazitätswert einer Gate-Source-Kapazität C_{GS}, die bei Feldeffekttransistoren zwischen der Gate-Elektrode G und der Source-Elektrode S vorhanden ist, und die in Figur 1 zum besseren Verständnis eingezeichnet ist. Zum anderen ist die Schaltzeit bestimmt durch einen Strom I2, der zum Umladen der Gate-Source-Kapazität C_{GS} von der Ansteuerschaltung ANS über die Ausgangsklemme AK an die Gate-Elektrode G des Halbleiterschalters TR fließt oder der von der Gate-Elektrode G über die Ausgangsklemme AK von der Ansteuerschaltung ANS aufgenommen wird. Dieser Strom I2 ist bei der dargestellten Ansteuerschaltung temperaturabhängig.

Zur Bereitstellung des Stromes I2 weist die dargestellte Ansteuerschaltung ANS eine Stromsenke und eine Stromquelle auf, denen eine Stromquelle Iq gemeinsam ist und wobei die Stromquelle einen Stromspiegel mit einem ersten und zweiten Transistor TR1, TR2 und die Stromsenke einen Stromspiegel mit einem dritten und vierten Transistor TR3, TR4 aufweist. Der erste und zweite Transistor TR1, TR2, deren Gate-Elektroden miteinander verbunden sind, sind in dem Ausführungsbeispiel als n-leitende Feldeffekttransistoren ausgebildet, deren Source-Anschlüsse an einen Knoten für ein Versorgungspotential V angeschlossen sind. Der dritte und vierte Transistor TR3, TR4, deren Gate-Elektroden ebenfalls miteinander verbunden sind, sind in dem Ausführungsbeispiel als p-leitende Feldeffekttransistoren ausgebildet, deren Source-Anschlüsse an einen Knoten für ein Bezugspotential M angeschlossen sind. Der erste und dritte Transistor TR1, TR3 sind als Dioden verschaltet, indem ihre Gate-Elektrode mit der Source-Elektrode verbunden ist. Die Stromquelle Iq ist zwischen die SourceElektroden des ersten und dritten Transistors TR1, TR3 geschaltet.

Zum Anschließen der aus der Stromquelle Iq und dem Stromspiegel TR1, TR2 bestehenden Stromquelle an die Anschlußklemme AK ist ein erster Schalter S1 zwischen die Source-Elektrode des zweiten Transistors TR2 und die Anschlußklemme AK geschaltet. Analog ist zum Anschließen der aus der Stromquelle Iq und dem Stromspiegel TR3, TR4 bestehenden Stromsenke an die Anschlußklemme AK ein zweiter Schalter S2 zwischen die Source-Elektrode des dritten Transistors TR3 und die Anschlußklemme AK geschaltet. Die erste und zweite Schalter S1, S2 sind nach Maßgabe eines Schaltsignals S1 über eine Ansteuereinheit AE ansteuerbar, der das Schaltsignal S1 an einer Eingangsklemme zugeführt ist und die Ausgangsklemmen A1, A2 aufweist, an die Steueranschlüsse des ersten bzw. zweiten Schalters angeschlossen sind. Der erste und zweite Schalter S1, S2 und die an den Ausgangsklemmen A1, A2 anliegenden Ansteuersignale sind vorzugsweise so aufeinander abgestimmt, daß jeweils nur einer der beiden Schalter S1; S2 leitet. Die Ansteuereinheit AE ist in dem dargestellten Beispiel als Verstärker ausgebildet mit einem nicht-invertierenden Ausgang, der an die Ausgangsklemme A1 angeschlossen ist, und mit einem invertierenden Ausgang, der an die Ausgangsklemme A2 angeschlossen ist.

Die Stromquelle Iq stellt einen temperaturabhängigen Strom I1 bereit. Die Einstellung des Stromes erfolgt nach Maßgabe eines einer Eingangsklemme der Stromquelle Iq zuführbaren Temperatursignals S3, welches von einem Temperatursensor TS bereitgestellt wird. Die Stromquelle Iq ist beispielsweise eine spannungsgesteuerte Stromquelle Iq, das Temperatursignal S3 dementsprechend eine temperaturabhängige Spannung, die zur Einstellung des Stromes I1 dient.

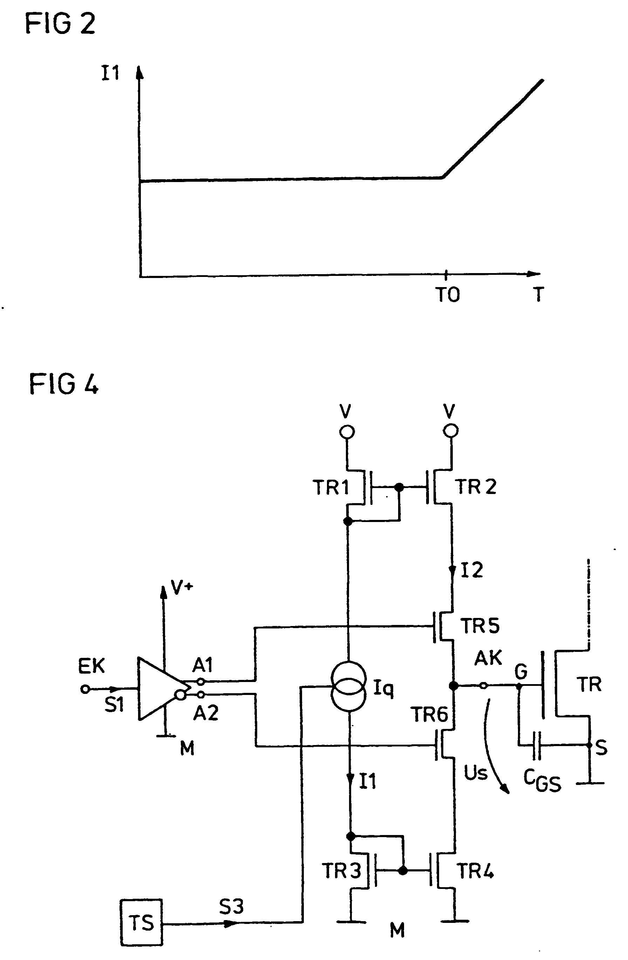

Das Temperatursignal S3 ist vorzugsweise bis zu einer Temperatur T0 konstant und steigt dann linear mit zunehmender Temperatur an, so daß sich für den Strom I1 der in Figur 2 dargestellte Verlauf ergibt. Der zur Ladung der Gate-Source-Kapazität C_{GS} an die Ausgangsklemme fließende Strom I2 bzw. der zur Entladung der Gate-Source-Kapazität C_{GS} von der Ausgangsklemme AK aufgenommene Strom I2 ist proportional zu dem Strom I1, wobei sich der Proportionalitätsfaktor aus den Stromspiegelverhältnissen des ersten und zweiten Stromspiegel TR1, TR2; TR3, TR4 ergibt, die vorzugsweise dieselben Stromspiegelverhältnisse besitzen.

Die Funktionsweise der dargestellten Schaltungsanordnung wird im folgenden kurz erläutert.

Bei zunächst entladener Gate-Source-Kapazität C_{GS} sperrt der MOSFET T. Wird der erste Schalter ST1 nach Maßgabe des Schaltsignals S1 geschlossen und der zweite Schalter ST2 geöffnet, fließt ein Strom I2 von der als Stromquelle wirkenden Anordnung aus erstem Stromspiegel TR1, TR2 und der Stromquelle Iq über die Ausgangsklemme AK der Ansteuerschaltung auf die Gate-Source-Kapazität C_{GS}. Der Anstieg, bzw. die Steilheit des Ansteuersignals Us ist dabei proportional zu dem Strom I2, der über das Stromspiegelverhältnis des ersten Stromsiegels TR1, TR2 von dem temperaturabhängigen Strom I1 abhängig ist. Liegt die Temperatur in dem Ausführungsbeispiel oberhalb T0 nimmt der Strom I2 mit weiter steigender Temperatur zu, wodurch die Steilheit des Ansteuersignals Us zunimmt. Der MOSFET geht dann schneller vom sperrenden in den leitenden Zustand über. Dies verstärkt zwar die elektromagnetische Abstrahlung, wirkt jedoch einer durch Verluste am MOSFET während des Schaltvorgangs bedingten weiteren Erwärmung der Schaltung entgegen. Das Ansteuersignal Us steigt in den dargestellten Ausführungsbeispiel so lange an, bis es etwa den Wert des Versorgungspotentials V abzüglich der über der Laststrecke des zweiten Transistors anfallenden Spannung erreicht.

Zum Sperren des MOSFET TR wird der zweite Schalter ST2 nach Maßgabe des Schaltsignals S1 geschlossen, der erste Schalter ST1 wird geöffnet. Die Gate-Source-Kapazität C_{GS} wird dann mit einem Strom I2 entladen, der durch die als Stromsenke wirkende Anordnung aus Stromquelle Iq und zweitem Stromspiegel TR3, TR4 bestimmt ist. Die Steilheit mit der das Ansteuersignal Us abnimmt ist proportional zu dem Strom I2, der über das Stromspiegelverhältnis des zweiten Stromspiegels TR3, TR4 von dem temperaturabhängigen Strom I1 abhängt. Liegt die Temperatur der Schaltung in dem Ausführungsbeispiel oberhalb T0 nimmt der Entladestrom I2 und damit die Steilheit des Ansteuersignals Us mit zunehmender Temperatur zu. Der MOSFET TR geht dann schneller vom leitenden in den sperrenden Zustand über. Dies verstärkt zwar die elektromagnetische Abstrahlung, wirkt jedoch einer weiteren durch Verluste am MOSFET während des Schaltvorgangs bedingten Erwärmung entgegen. Das Ansteuersignal sinkt bis es etwa einen Wert erreicht, der in dem Beispiel in Figur 1 durch die Laststrekkenspannung des vierten Transistors TR4 gegeben ist.

Der Verlauf eines Schaltvorgangs ist für zwei unterschiedliche Temperaturen T=T1 und T=T2, wobei T2>T1 gilt, beispielhaft in Figur 3 veranschaulicht. Wechselt das Schaltsignal S1 von einem unteren Pegel S1L zu einem oberen Pegel S1H steigt das Ansteuersignal Us von einem unteren Ansteuerpegel UsL zu einem oberen Ansteuerpegel UsH an. Die Steilheit des Anstiegs ist von dem an die Ausgangsklemme AK fließenden temperaturabhängigen Strom I2 abhängig. Der Anstieg erfolgt um so schneller je größer der Strom I2 bzw. je größer die Temperatur ist. Wechselt das Schaltsignal von dem oberen Ansteuerpegel S1H zu dem unteren Ansteuerpegel S1L, sinkt das Ansteuersignal Us von dem oberen Ansteuerpegel zu dem unteren Ansteuerpegel ab, wobei der Abfall um so steiler erfolgt um so größer der Entladestrom I2 bzw. um so größer die Temperatur ist.

Figur 4 zeigt ein Ausführungsbeispiel der erfindungsgemäßen Schaltung, bei dem die Schalter S1, S2 als Feldeffekttransistoren TR5, TR6 ausgebildet sind, deren Gate-Elektroden an die Ausgangsklemmen A1, A2 der Ansteuereinheit AE angeschlossen sind.

Die nach Maßgabe des Schaltsignals S1 an den Ausgangsklemmen A1, A2 anliegenden High- oder Low-Pegel zur Ansteuerung der Feldeffekttransistoren TR5, TR6 sind so gewählt, daß die Feldeffekttransistoren TR5, TR6 unabhängig von dem Ansteuersignal Us sicher leiten oder sicher sperren. Der High-Pegel am Ausgang der Ansteuereinheit AE liegt daher vorzugsweise über dem Wert des Versorgungspotentials V, der Low-Pegel vorzugsweise unterhalb des Wertes der über der Laststrecke des vierten Transistors TR4 abfallenden Spannung.

Die in den Figuren 1 und 2 dargestellten Schaltungen verhalten sich bis zu einer Temperatur T0 wie eine herkömmliche Schaltungsanordnung zur Ansteuerung eines Halbleiterschalters. Die Schaltgeschwindgkeit des Halbleiterschalters ist zu Gunsten einer verringerten elektromagnetischen Abstrahlung reduziert, wodurch jedoch die Verluste an dem Halbleiterschalter zunehmen. Oberhalb der Temperatur nimmt die Schaltgeschwindigkeit mit zunhemender Temperatur zu, um die Verluste an dem Halbleiterschalter zu verringern und eine weitere Erwärmung der Schaltung zu verhindern. Selbstverständlich besteht auch die Möglichkeit, die Schaltgeschwindigkeit über den gesamten Temperaturbereich temperaturabhängig zu regeln. Der von der Stromquelle Iq gelieferte Strom I1 würde dann über den gesamten Temperaturbereich mit zunehmender Temperatur ansteigen.

Des weiteren ist es möglich, abhängig davon, ob die Temperatur oberhalb oder unterhalb der Temperaturschwelle T0 liegt, nur zwei Flankensteilheiten für das Ansteuersignal Us, durch Bereitstellung eines nur zwei unterschiedliche Werte annehmenden Stromes I1 vorzusehen.

### Bezugszeichenliste:

- EK: Eingangsklemme
- AK: Ausgangsklemme
- Vdd: Versorgungspotential
- V: Versorgungspotential
- TR1, TR2: Stromspiegeltransistoren
- TR3, TR4: Stromspiegeltransistoren
- Iq: Stromquelle
- I1, I2: Temperaturabhängige Ströme
- ST1: erster Schalter
- ST2: zweiter Schalter
- L: Lastinduktivität
- TR: Halbleiterschalter
- ANS: Ansteuerschaltung
- T1, T2: Temperatur
- T0: Temperatur
- S1: Schaltsignal
- TS: Temperatursensor
- S3: Temperatursignal
- M: Bezugspotential
- TR5, TR6: Transistoren
- C_{GS}: Gate-Source-Kapazität
- V+: Versorgungspotential der Ansteuereinheit
- AE: Ansteuereinheit
- S1L: unterer Pegel des Schaltsignals
- S1H: oberer Pegel des Schaltsignals
- UsL: unterer Pegel des Ansteuersignals
- UsH: oberer Pegel des Ansteuersignals

## Patentansprüche

1. Schaltungsanordnung mit einem Halbleiterschalter (T) und einer Ansteuerschaltung (ANS), die eine Eingangsklemme (EK) zum Anlegen eines Schaltsignals (S1) und eine an einen Steuereingang des Halbleiterschalters (T) angeschlossene Ausgangsklemme (AK) zum Bereitstellen eines Ansteuersignals (Us) nach Maßgabe des Schaltsignals (S1) aufweist,
**dadurch gekennzeichnet, dass**
die Steilheit des Ansteuersignals (Us) bei einem Wechsel vom einem ersten Ansteuerpegel (UsL; UsH) zu einem zweiten Ansteuerpegel (UsH, UsL) temperaturabhängig gesteuert wird, wobei die Steilheit bei Erreichen einer vorgegebenen Temperaturschwelle (T0) zunimmt.

2. Schaltungsanordnung nach Anspruch 1,
**dadurch gekennzeichnet, daß**
die Steilheit mit zunehmender Temperatur zunimmt.

3. Schaltungsanordnung nach Anspruch 1 oder 2,
**dadurch gekennzeichnet, daß**
die Ansteuerschaltung (ANS) eine Stromquelle zur Bereitstellung eines temperaturabhängigen Stromes aufweist.

4. Schaltungsanordnung nach einem der vorangehenden Ansprüche,
**dadurch gekennzeichnet, daß**
die Stromquelle nach Maßgabe des Schaltsignals (S1) an die Ausgangsklemme (AK) anschließbar ist.

5. Schaltungsanordnung nach einem der vorangehenden Ansprüche,
**dadurch gekennzeichnet, daß**
die Ansteuerschaltung (ANS) eine Stromquelle (Iq, T1, T2) und eine Stromsenke (Iq, T3, T4) aufweist zur Abgabe eines temperaturabhängigen Stromes (I2) an die Ausgangsklemme (AK) oder zur Aufnahme eines temperaturabhängigen Stromes (I2) von der Ausgangsklemme (AK).

6. Schaltungsanordnung nach Anspruch 5,
**dadurch gekennzeichnet, daß**
die Ansteuerschaltung (ANS) einen ersten Schalter (ST1) zum Anschließen der Stromquelle (Iq, T1, T2) und einen zweiten Schalter (ST2) zum Anschließen der Stromsenke (Iq, T3, T4) an die Ausgangsklemme (AK) nach Maßgabe des Schaltsignals (S1) aufweist.

7. Schaltungsanordnung nach einem der Ansprüche 3 bis 6,
**dadurch gekennzeichnet, daß**
der Strom (I2) mit steigender Temperatur zunimmt.

8. Schaltungsanordnung nach Anspruch 7,
**dadurch gekennzeichnet, daß**
der Strom (I2) ab Erreichen einer vorgebbaren Temperaturschwelle (T0) mit steigender Temperatur zunimmt

9. Schaltungsanordnung nach einem der vorangehenden Ansprüche,
**dadurch gekennzeichnet, daß**
die Ansteuerschaltung (ANS) eine Ansteuereinheit (AE) zur Ansteuerung der Schalter (ST1, ST2) nach Maßgabe des Schaltsignals (S1) aufweist, der das Schaltsignals (S1) zuführbar ist.

10. Schaltungsanordnung nach einem der vorangehenden Ansprüche,
**dadurch gekennzeichnet, daß**
sie einen an die Stromquelle (Iq, T1, T2) und Stromsenke (Iq, T3, T4) angeschlossenen Temperatursensor (TS) zur Einstellung des Stromes (I2) aufweist.

11. Schaltungsanordnung nach einem der vorangehenden Ansprüche,
**dadurch gekennzeichnet, daß**
der Halbleiterschalter (TR) ein Leistungs-MOSFET ist.

12. Schaltungsanordnung nach einem der vorangehenden Ansprüche,
**dadurch gekennzeichnet, daß**
die Schalter (ST1, ST2) Transistoren (TR5, TR6) sind, denen zur Ansteuerung von der Ansteuereinheit (AE) ein von dem Schaltsignal (S1) abhängiges Signal zugeführt ist.

## Claims

1. Circuit arrangement having a semiconductor switch (T) and a drive circuit (ANS), which has an input terminal (EK) for applying a switching signal (S1) and an output terminal (AK), connected to a control input of the semiconductor switch (T), for supplying a drive signal (Us) on the basis of the switching signal (S1),
**characterized in that**
the gradient of the drive signal (Us) during a change from a first drive level (UsL; UsH) to a second drive level (UsH, UsL) is controlled in a temperature-dependent manner, where the gradient increases when a predetermined temperature threshold (T0) is reached.

2. Circuit arrangement according to Claim 1, **characterized in that** the gradient increases with rising temperature.

3. Circuit arrangement according to Claim 1 or 2, **characterized in that** the drive circuit (ANS) has a current source for supplying a temperature-dependent current.

4. Circuit arrangement according to one of the preceding claims, **characterized in that** the current source can be connected to the output terminal (AK) on the basis of the switching signal (S1).

5. Circuit arrangement according to one of the preceding claims, **characterized in that** the drive circuit (ANS) has a current source (Iq, T1, T2) and a current sink (Iq, T3, T4) for outputting a temperature-dependent current (I2) to the output terminal (AK) or for receiving a temperature-dependent current (I2) from the output terminal (AK).

6. Circuit arrangement according to Claim 5, **characterized in that** the drive circuit (ANS) has a first switch (ST1) for connecting the current source (Iq, T1, T2) and a second switch (ST2) for connecting the current sink (Iq, T3, T4) to the output terminal (AK) on the basis of the switching signal (S1).

7. Circuit arrangement according to one of Claims 3 to 6, **characterized in that** the current (I2) rises with rising temperature.

8. Circuit arrangement according to Claim 7, **characterized in that** the current (I2) rises with rising temperature after a predeterminable temperature threshold (T0) has been reached.

9. Circuit arrangement according to one of the preceding claims, **characterized in that** the drive circuit (ANS) has a drive unit (AE) for driving the switches (ST1, ST2) on the basis of the switching signal (S1), where the switching signal (S1) can be supplied to said drive unit (AE).

10. Circuit arrangement according to one of the preceding claims, **characterized in that** it has a temperature sensor (TS) connected to the current source (Iq, T1, T2) and to the current sink (Iq, T3, T4) for setting the current (I2).

11. Circuit arrangement according to one of the preceding claims, **characterized in that** the semiconductor switch (TR) is a power MOSFET.

12. Circuit arrangement according to one of the preceding claims, **characterized in that** the switches (ST1, ST2) are transistors (TR5, TR6) to which, for driving, the drive unit (AE) supplies a signal which is dependent on the switching signal (S1).

## Revendications

1. Montage avec un commutateur semi-conducteur (T) et un circuit de commande (ANS) qui présente une borne d'entrée (EK) pour appliquer un signal de commutation (S1), et une borne de sortie (AK) raccordée à une entrée de commande du commutateur semi-conducteur (T) pour préparer un signal de commande (Us) conformément au signal de commutation (S1),
**caractérisé en ce que**
la pente du signal de commande (Us) est commandée en fonction de la température lors d'un passage d'un premier niveau de commande (UsL ; UsH) à un deuxième niveau de commande (UsH ; UsL), la pente augmentant lorsqu'un seuil de température prédéfini (T0) est atteint.

2. Montage selon la revendication 1,
**caractérisé en ce que**
la pente augmente lorsque la température augmente.

3. Montage selon la revendication 1 ou 2,
**caractérisé en ce que**
le circuit de commande (ANS) présente une source de courant pour préparer un courant variable avec la température.

4. Montage selon l'une quelconque des revendications précédentes,
**caractérisé en ce que**
la source de courant peut être raccordée à la borne de sortie (AK) en fonction du signal de commutation (S1).

5. Montage selon l'une quelconque des revendications précédentes,
**caractérisé en ce que**
le circuit de commande (ANS) présente une source de courant (Iq, T1, T2) et un puits de courant (Iq, T3, T4) pour fournir un courant variable avec la température (I2) sur la borne de sortie (AK) ou pour recueillir un courant variable avec la température (I2) provenant de la borne de sortie (AK).

6. Montage selon la revendication 5,
**caractérisé en ce que**
le circuit de commande (ANS) présente un premier commutateur (ST1) pour raccorder la source de courant (Iq, T1, T2), et un deuxième commutateur (ST2) pour raccorder le puits de courant (Iq, T3, T4) à la borne de sortie (AK) en fonction du signal de commutation (S1).

7. Montage selon l'une quelconque des revendications 3 à 6,
**caractérisé en ce que**
le courant (I2) augmente lorsque la température augmente.

8. Montage selon la revendication 7,
**caractérisé en ce que**
le courant (I2) augmente, après avoir atteint un seuil de température (T0) prédéfinissable, lorsque la température augmente.

9. Montage selon l'une quelconque des revendications précédentes,
**caractérisé en ce que**
le circuit de commande (ANS) présente une unité de commande (AE) pour commander le commutateur (ST1, ST2) conformément au signal de commutation (S1) auquel le signal de commutation (S1) peut être amené.

10. Montage selon l'une quelconque des revendications précédentes,
**caractérisé en ce qu'**
il présente un capteur de température (TS) raccordé à la source de courant (Iq, T1, T2) et au puits de courant (Iq, T3, T4) pour régler le courant (I2).

11. Montage selon l'une quelconque des revendications précédentes,
**caractérisé en ce que**
le commutateur semi-conducteur (TR) est une puissance MOSFET.

12. Montage selon l'une quelconque des revendications précédentes,
**caractérisé en ce que**
les commutateurs (ST1, ST2) sont des transistors (TR5, TR6) auxquels est amené un signal dépendant du signal de commutation (S1) pour commander l'unité de commande (AE).
